# EUROPÄISCHE PATENTANMELDUNG

(11) **EP 0 740 975 A1**
(43) Veröffentlichungstag der Anmeldung: **06.11.1996**
(21) Anmeldenummer: 95106841.0
(22) Anmeldetag: 05.05.1995
(51) Int. Cl.: B23K 1/008

(54) **Verfahren zum Wellenlöten mit bleifreien Lotmaterialien**

(71) Anmelder: Linde Aktiengesellschaft, 65189 Wiesbaden (DE); EPM Handels AG, CH-8035 Zürich (CH)
(72) Erfinder: Wandke, Ernst, Dr.-Ing., D-82538 Geretsried (DE); Isler, Hans, CH-8967 Widen (CH)
(74) Vertreter: Kasseckert, Rainer

(57) **Zusammenfassung**

Die Erfindung betrifft ein Verfahren zum Wellenlöten von Baugruppen, insbes. bestückten Leiterplatten, unter Abschirmung von der Umgebung, bei dem bleifreie oder zumindest bleiarme Lote, insbesondere Zinnlote, mit einem Schmelzpunkt von mehr als 210°C zur Anwendung kommen. Da beim Wellenlöten die Lotbadtemperatur üblicherweise deutlich höher eingestellt sein muß als der Schmelzpunkt des jeweiligen Lotes liegt, treten mit den höherschmelzenden, bleifreien oder bleiarmen Loten Überhitzungsprobleme bei den zu verlötenden Bauelementen auf. Als Lösung für dieses Problem wird erfindungsgemäß vorgeschlagen, daß eine Lotbadtemperatur von lediglich einigen Celsiusgraden über dem Schmelzpunkt des jeweiligen Lotmaterials eingestellt wird und und daß der Wellenlötvorgang unter Plasmawirkung einer Prozeßgas-Atmosphäre unter Niederdruck durchgeführt wird.

## Beschreibung

Die Erfindung betrifft ein Verfahren zum Wellenlöten von Baugruppen, insbes. bestückten Leiterplatten, unter Abschirmung von der Umgebung, bei dem bleifreie oder zumindest bleiarme Lote, insbesondere Zinnlote, mit einem Schmelzpunkt von mehr als 210°C zur Anwendung kommen.

In sehr weitem Umfang werden heute zum Weichlöten von elektronischen Bau-teilen bleireiche Zinn/Blei-Lote mit einem Schmelzpunkt von etwa 185 °C eingesetzt. Dabei ist insbesondere beim Wellenlötverfahren, also bei einem Verfahrensprinzip, bei dem das Lot mittels einer Welle flüssigen Lots auf das Werkstück übertragen wird, so vorzugehen,daß das zugehörige Lotbad, aus dem heraus die Welle gebildet wird, auf eine Temperatur eingestellt wird,die 50 bis 60°C über dem Schmelzpunkt des jeweiligen Lots liegt. Diese Temperatureinstellung dient zu einem wesentlichen Teil dazu, ein günstig viskoses Lot zur erhalten, das in der Folge fehlerfreie und hochwertige Lötverbindungen ausbildet.

Falls ausgehend von diesem Verfahrensprinzip höherschmelzende, bleiarme oder bleifreie Lote zur Anwendung kommen - was heute aus Gründen des Umweltschutzes in zunehmendem Maße angestrebt wird - resultiert, daß auch entsprechend höhere Lotbadtemperaturen einzustellen sind. Die betreffenden bleifreien oder bleiarmen Lote weisen generell zumindest einen um etwa 30°C höhere Schmelzpunkt als die gängigen eutektischen Zinn/Blei-Lote auf, die bei ca. 183°C schmelzen und die mit einer Lotbadtemperatur von ca. 240°C verarbeitet werden (siehe beispielsweise Artikel "Weichlöten unter aktiviertem Schutzgas - ..." aus ELEKTRONIK PRODUKTION & PRÜFTECHNIK - April 1989, S. 37-39, insbes. S. 37, mittlere Spalte). Demgegenüber sind die hier angesprochenen Lote mit Lotbadtemperaturen von zumindest etwa 260°C zu verarbeiten.

Bei Lotbadtemperaturen von mehr als 250 °C besteht aber eine deutlich erhöhte Gefahr, daß einzulötende elektronischen Bauteile thermisch beschädigt werden. Es ergibt sich also der Umstand, daß Baugruppen nicht oder nur mit höheren Ausschußraten mit bleifreien oder bleiarmen Loten mit höherliegenden Schmelzpunkten gelötet werden können (zu Temperaturüberlegungen beim Löten siehe beispw. DE-OS 40 16 366).

Die Aufgabenstellung zu vorliegender Erfindung bestand daher darin, ein Wellenlötverfahren für bleifreie oder bleiarme, höherschmelzende Lote mit Schmelztemperaturen von mehr als 210 °C anzugeben, daß mit einer geringeren thermischen Belastung der zu verlötenden Bauteile als die bekannten Wellenlötverfahren auskommt.

Diese Aufgabenstellung wird gemäß vorliegender Erfindung dadurch gelöst, daß die jeweilige Lotbadtemperatur lediglich einige Celsiusgrade über dem Schmelzpunkt des jeweiligen Lotmaterials eingestellt wird
und daß der Lötvorgang unter Plasmawirkung einer geeigneten Prozeßgas-Atmosphäre unter Niederdruck durchgeführt wird.

Mit dem Löten unter Plasmaeinwirkung, wie es aus der DE-A1 42 25 378 bekannt ist, ist es überraschenderweise möglich die Lotbadtemperatur deutlich näher am Schmelzpunkt des jeweiligen Lotes einzustellen und trotzdem ein hochwertiges Lötergebnis zu erhalten. Wie bereits ausgeführt dient die erheblich über dem Schmelzpunkt liegende Temperatureinstellung des Lotbades bei herkömmlichen Verfahren dazu, ein günstig dünnflüssiges Lot zu erhalten, das eine gute Benetzungsfähigkeit und Spaltgängigkeit aufweist und somit zu guten Lötergebnissen führt. Wie nun die Anmelderin festgestellt hat, weist Lot, das unter Plasmaeinwirkung bei entsprechenden Niederdruckbedingungen verarbeitet wird, bereits bei wenig über dem Schmelzpunkt liegenden Temperaturen ebenfalls gerade diese Eigenschaften in ausreichendem Maße auf und liefert also bereits dann hochwertige Lötverbindungen. Somit ist es also erfindungsgemäß möglich, mit abgesenkten Lotbadtemperaturen zu arbeiten, was insbesondere die Anwendung bleifreier, höherschmelzender Lote vor allem auf der Basis von Zinn oder Zink, beispielsweise die von Zinn-Silber-Loten, wesentlich verbessert und universeller macht (zu Loten siehe beispielsweise DVS Fachbuchreihe Schweißtechnik, Band 108, 1990, "Metallische Lotwerkstoffe" oder Taschenbuch "Hütte", 22. Auflage., 1915, insbesondere S.681).

Prinzipiell ist das Verfahren hinsichtlich der Niederdruckbedingungen und der Plasmabildung - wie im Ausführungsbeispiel noch gezeigt wird - gemäß der schon genannten DE-A1 42 25 378 auszugestalten, wobei jetzt allerdings nicht mehr die Standardbedingungen hinsichtlich der Lotbadtemperatur eingehalten werden.

Mit entscheidendem Vorteil wird nunmehr - gemäß der Erfindung - eine Lotbadtemperatur eingestellt, die lediglich um 3 bis 20°C, vorzugsweise 5 bis 15°C, über dem Schmelzpunkt des jeweils angewandten Lotes liegt.

In einer einfachen, durchaus funktionstüchtigen Variante der Erfindung wird ferner als Prozeßgas Luft - optionsweise mit Beimischungen beispielsweise aus Wasserstoff und/oder Stickstoff - angewendet. Bessere Ergebnisse werden jedoch dann erzielt, wenn als Prozeßgas ein Gas aus der Gruppe N₂, Ar, O₂, H₂, SF₆, FKW (= Fluorkohlenwasserstoffe) oder FCKW (= Fluorchlorkohlenwasserstoffe) oder eine Mischung davon angewendet wird. Eine besonders effektive Version der Erfindung ergibt sich mit einem gleichzeitig sowohl reduzierend wie oxidierend wirkenden Prozeßgas, das aus einem Gasgemisch aus
0,5 bis 10 Vol-% O₂,
80 bis 20 Vol-% H2 und
20 bis 80 Vol-% CF4 oder SF6 und
optionsweise bis zu 50 Vol-% Ar oder N2 besteht.

Im folgenden wird die Erfindung anhand eines Ausführungsbeispiels näher beschrieben.

Zur Wellenlötung von bestückten Leiterplatten wird ein 3% Silber enthaltendes Zinnlot eingesetzt. Dieses SnAg 3-Lot besitzt eine Schmelztemperatur von 220°C und ist also im Lotbad einer Lötanlage, wie sie etwa die bereits mehrfach zitierte DE 42 25 378 enthält, vorzusehen. Eine solche, für die Erfindung geeignete Lötanlage ist insbesondere dadurch gekennzeichnet ist, daß sie eine gasdichte, zumindest die Lötstation umfassende Anlagenkammer aufweist sowie Mittel, um in dieser Kammer einen Niederdruck zu erzeugen, als auch Mittel, um dort eine Niederdruckatmosphäre im Plasmazustand zu bilden (beispielsweise einen Hochfrequenzwellengenerator).

In einer solchen Anlage wird nun gemäß der Erfindung lediglich eine Lotbadtemperatur von 225 bis 230°C eingestellt und andererseits aus einem Prozeßgas, das unter einem Druck im Bereich von 0,1 bis 10 mbar steht, ein Plasma erzeugt, d.h. es wir ein ionsierte Atome und/oder Moleküle und freie Elektronen enthaltendes Gas gebildet. Ein erfindungsgemäß besonders geeignetes Gas hierzu enthält 2 bis 8 Vol-% O₂, 40 bis 60 % H₂ und 30 bis 55 % Tetrafluormethan (CF4). Werden unter Einhaltung der geschilderten Temperaturbedingungen und unter Aufrechterhaltung des Plasmas Leiterplatten durch die besagte, im allgemeinen tunnelartige Wellenlötanlage geführt, die außerdem mit Zutritts- und Austrittsschleusen versehen sein muß, so ergibt sich auch mit der geschilderten, niedrigliegenden, unüblichen Lotbadtemperatur eine hochwertige Lötung der vorhandenen Lötpartner (d.h. im Regelfall einerseits der Stifte der Bauelemente und andererseits der Fassungen in der Leiterplatte).

Es gelingt also eine Wellenlötung mit deutlich niedereren Lotbadtemperaturen auszuführen, als dies ansonsten üblicherweise der Fall ist und als dies bei unter Normaldruck und ohne Plasmabildung arbeitenden Standardlötanlagen überhaupt möglich wäre. Beispielsweise wären bei Lötanlagen, wie sie in dem einleitend genannten Fachartikel "Weichlöten unter aktiviertem Schutzgas - ..." enthalten sind, bei dem besagtem Zinn/Silber-Lot Lotbadtemperaturen von wenigstens 270°C einzustellen, womit die Wahrscheinlichkeit einer thermischen Schädigung von vorhandenen Bauelementen wesentlich höher läge. Neben Energieeinsparungen und einem qualitativ hochwertigen Lötprozeß liegt in diesem thermisch schonenden Lötprozeß der wesentliche Vorteil, der mit der Erfindung erzielt wird.

## Patentansprüche

1. Verfahren zum Wellenlöten von Baugruppen, insbesondere bestückten Leiterplatten, unter Abschirmung von der Umgebung, bei dem bleifreie oder zumindest bleiarme Lote, insbesondere Zinnlote, mit einem Schmelzpunkt von mehr als 210°C zur Anwendung kommen,
**dadurch gekennzeichnet**, daß eine Lotbadtemperatur von lediglich einigen Celsiusgraden über dem Schmelzpunkt des jeweiligen Lotmaterials eingestellt wird
und daß der Lötvorgang unter Plasmawirkung einer Prozeßgas-Atmosphäre unter Niederdruck durchgeführt wird.

2. Verfahren nach Anspruch 1, dadurch gekennzeichnet, daß das Prozeßgas Luft, optionsweise mit Stickstoff- und/oder Wasserstoffbeimischungen, ist.

3. Verfahren nach Anspruch 1, dadurch gekennzeichnet, daß als Prozeßgas ein Gas aus der Gruppe N2, Ar, O2, H2, SF6, FKW oder FCKW oder eine Mischung aus diesen vorgesehen wird.

4. Verfahren nach Anspruch 3, dadurch gekennzeichnet, daß als Prozeßgas ein Gasgemisch aus 0,5 bis 10 Vol-% O2,
80 bis 20 Vol-% H2 und
20 bis 80 Vol-% CF4 oder SF6 mit
optionsweise bis zu 50 Vol-% Ar oder N2 vorgesehen wird.

5. Verfahren nach einem der Ansprüche 1 bis 4, dadurch gekennzeichnet, daß die Lotbadtemperatur um 3 bis 20°C, vorzugsweise 5 bis 15°C,über dem Schmelzpunkt des jeweils angewandten Lotes eingestellt wird.
